# EUROPEAN PATENT APPLICATION

(11) **EP 0 565 784 A1**
(43) Date of publication of application: **20.10.1993**
(21) Application number: 92203051.5
(22) Date of filing: 05.10.1992
(51) Int. Cl.: G03F 1/14

(54) **Method of manufacturing X-ray exposure mask**

(30) Priority: 07.04.1992 JP 85558/92
(71) Applicant: TOKYO INSTITUTE OF TECHNOLOGY, Tokyo (JP)
(72) Inventor: Furuya, Kazuhito, Yokohama City, Kanagawa Pref. (JP); Miyamoto, Yasuyuki, Higashikurume City, Tokyo (JP)
(74) Representative: Flamman, Han

(57) **Abstract**

The present invention relates to a method of manufacturing an exposure mask having an unprecedented supermicrostructure for an X-ray exposure method favorable for conventional supermicro exposure, in lithography technique.

A method of manufacturing an X-ray exposure mask comprising the steps of alternately laminating two kinds of compound semiconductors 2, 4 and 3, 5 as a thin film layer having a periodic structure with controlability of about one atomic layer on a substrate 1, selectively etching only one material for forming the periodic structure, forming uneven difference between adjacent layers of said laminate body, and manufacturing a mask 14 for exposing streaks on a desired resist 15 with the aid of difference of X-ray absorption amounts between each layer by exposing X-ray in parallel to the direction of the laminate layer.

## Description

The present invention relates to a method of manufacturing an exposure mask having an unprecedented supermicrostructure for an X-ray exposure method favorable for conventional supermicro exposure, in lithography technique advancing toward microminiaturization for better performance of high density integrated circuits and transistors in electronic field.

In lithography technique, an X-ray exposure favorable for a conventional supermicro exposure is an exposure method which can break beyond an applicable limit by optical wavelength of conventional exposure.

However, as a new applicable limit of an X-ray exposure method, the manufacture of an exposure mask has emerged. As a mask for preventing X-rays, there is required to form a fine pattern of metal such as gold, tungsten and the like on a thin film. At present, an electron beam exposure method has been widely used as technique which is not mass-producible but can draw a comparatively fine pattern, so that a trial for forming a fine metal pattern in combination of this exposure method with etching, lift-off method and plating method is most popular as a mask manufacturing method. However, it is very difficult to form a superfine metal pattern having a sufficient thickness by scattering electron beams in resist or in structure under resist such as metal, substrate and the like, which is a problem of supermicrostructure in electron beam exposure method, and supermicro-structure of about 10 nm of frequency at present, and this is a substantial applicable limit.

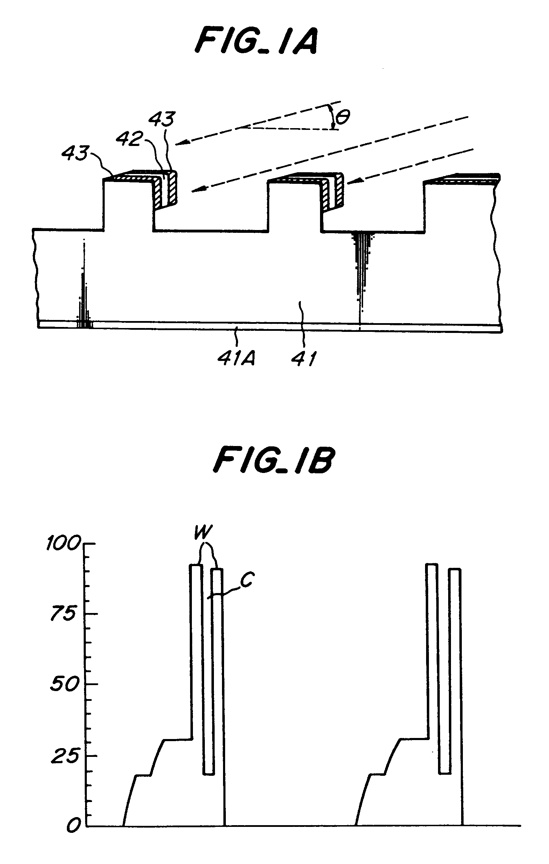

On the other hand, in the formation of layer structure, it is easy to provide film thickness controlability of about 1 nm. Therefore, as an example of a mask using layer structure, a method by oblique deposition is reported (see Appln. Phys. Lett., 36 (1), 1 Jan. 1980, American Institute of Physics). According to this method, as shown in Figs. 1A and 1B, a mask of about 2 nm in minimum ray width is formed on a periodically square-wave polyimide membrane by oblique deposition of carbon and tungsten, and a fine ray structure up to 17.5 nm is formed. However, the use of an oblique deposition method cannot minimize the period of a square wave.

At present, a thin film crystal growth method is most minutely studied in a method of forming a layer structure, and particularly in compound semiconductor crystal growth, composition switching controlability of less than one atomic layer is materialized. At the same time, it is possible to grow crystal to the whole side surface of a deep groove. These advantages are due to crystal growth under such condition that migration of a growing seed on the crystal surface is taken large for maintaining flatness. Moreover, if thin film crystal growth is carried out by using developing one atomic layer epitaxial technique, it is possible to form a thin film at one atomic layer interval on the whole growth surface.

X-ray exposure is a method breaking beyond a limit by optical wavelength of the conventional exposure with the use of X-ray, but as a new problem, the difficulty of manufacturing an exposure mask has emerged. That is, it is very difficult to form a very fine mask which can prevent X-ray with 10 nm order required as an X-ray mask.

The present invention is to obviate said shortcoming of the conventional methods and to provide a method of forming an X-ray mask having a ultra-fine structure.

One object of the present invention is to provide a method of forming an X-ray exposure mask of a fine structure having a precision of less than one atomic layer and an X-ray mask having an unprecedented tight supermicrostructure by enabling to form a thin film for a mask on and a side surface of a groove having narrow spaces by using a thin film crystal growth method.

The another object of the present invention relates to a method of manufacturing an X-ray exposure mask comprising the steps of alternately laminating two kinds of compound semiconductors as a thin film having a periodic structure with controlability of about one atomic layer on a substrate, selectively etching only one material forming the periodic structure, forming an uneven difference between adjacent layers of said laminate body, and manufacturing a mask for exposing stripes on a desired resist with the aid of a difference of X-ray absorption amounts between each layer and by exposing X-ray in parallel to the direction of the laminate layer.

The present invention enables to form an X-ray mask having a precedented tight supermicrostructure by using a thin film crystal growth method. In this mask, it is fundamental to transmit X-ray through the layer of crystal structure deposited in the thickness direction of layer so as to cross its interface in parallel thereto.

In comparison with the conventional method with the use of the same layer structure obtained by oblique deposition, the crystal growth method according to the present invention has the following three advantageous points.

First, a pattern can be formed with high precision because a flat film thickness controlability of less than one atomic layer can be obtained.

Second, the thin film crystal growth to the whole side surface of a deep groove is possible, so that a thin film crystal growth on the side surface of the deep groove can be increased in density when the thin film is used for preventing X-ray.

These advantages are obtained under the condition of taking migration of a growing seed large on the crystal surface for maintaining flatness in thin film crystal growth.

Third, with the use of the recently developed atomic layer expitaxy technique, a growing rate on the side surface and that the same are made on the plane regardless of the depth of a groove, and a very close pattern can be formed at one atomic layer intervals.

On the other hand, the present invention is limited in combination of materials for growing crystal, and has a serious problem whether a contrast as a mask can sufficiently be taken. Therefore, when an absorption coefficient of a typical material is calculated on the basis of a lattice matched compound semiconductor, what takes the largest difference of absorption coefficient between lattice matched compound semiconductors is a combination of GaP/AlP and Al-L lines. In this combination, there are obtained a value 10 of contrast when X-ray passing length is 1.57 µm and a value 8 of contrast when X-ray passing length is 1.41 µm. If X-ray passing length of Aℓ-L line is 10 µm, contrast takes 20,000,000 and the attenuation of X-ray by AlP is limited to 1/4.

On the other hand, in case of a combination of materials having small difference of absorption coefficient, a mask of high contrast can be obtained by removing one portion by selective etching after crystal growth. For example, a combination of GaAs and C-K line enables contrast 10 in thickness of 0.17 µm and contrast 8 in thickness of 0.15 µm, which is substantially the same absorption coefficient as that of gold as a typical X-ray absorber in Al-L line. Therefore, even if compound semiconductor for carrying out very precise crystal growth is only used, an X-ray mask can sufficiently be formed.

A substrate is the simple support of a thin film laminate body to be adhered, so that there is no particular limitation, but in order to adhere a compound semiconductor thin layer, the substrate should be a crystal body for forming a thin film having uniform thickness and smoothness for a joint area.

For the better understanding of the invention, reference is made to the accompanying drawings, in which:
Figs. 1(A) and 2(B) are a cross-sectional view for explaining a prior art and an X-ray absorption characteristic diagram.
Figs. 2(A) and 2(B) are perspective views for explaining a method of manufacturing an X-ray exposure mask according to the present invention.
Fig. 3 is a perspective view for explaining the method of manufacturing the X-ray exposure mask according to the present invention.
Fig. 4 is a cross-sectional view of an X-ray exposure device used for the present invention.
Figs. 5(A) and 5(B) are perspective view for explaining an enlarged part of Fig. 4.
Fig. 6 is a schematic view of an X-ray exposure mask by an epitaxial crystal growth according to the present invention.
Fig. 7 is a schematic view showing a process of manufacturing an X-ray exposure mask according to the present invention.
Fig. 8 is a schematic view showing the process of manufacturing the X-ray exposure mask according to the present invention.
Fig. 9 is a schematic view of a flange of the device for manufacturing the X-ray exposure mask according to the present invention.
Fig. 10 is an explanatory view showing a transcription condition of the X-ray exposure mask according to the present invention to a resist.
Figs. 11(A) and 11(B) show exposure with the use of the X-ray exposure mask according to the present invention.
Fig. 12 is an enlarged cross-sectional view showing a trnascription condition of the X-ray exposure mask according to the present invention to a resist (PMMA) on a substrate.
Fig. 13 is an explanatory view showing an allowable range of angle deviation in case of using the X-ray exposure mask according to the present invention and exposing to X-ray.
Fig. 14 shows intensity distribution in case of using the X-ray exposure mask according to the present invention.
Fig. 15 is a graph of intensity distribution to each value of a waveguide width T in case of using the X-ray exposure mask according to the present invention.
Fig. 16 is a graph showing the minimum value (2y) of a pitch to the width of a core in case of using the X-ray exposure mask according to the present invention.

Throughout different views of the drawing in Figs. 1-16, 1 is an InP substrate, 2, 4 are a GaInAs thin film layer, 3, 5 are an InP thin film layer, 6 is a recessed portion, 7 is a direction of X-ray, H is an optical path length of X-ray, 8 is an electron gun, 9 is a Cu-target, 19 is an X-ray, 11 is a stage, 12 is a sample, 13 is a vacuum pump, 14 is a mask, 15 is a PMMA resist, 16 is an Si substrate, 17 is a direction of X-ray, L is a length acting as a mask, d is an optical path length of X-ray, Q is an angle for applying X-ray, 18 is an incident X-ray, 19 is an output X-ray, 20 is a stage, 21 is a transcription substrate, 22 is a resist, 23 is a mask substrate, 24 is an X-ray absorbent, 25 is an incident electron ray, 26 is a Cu-target, 27 is a mask, 28 is a stage, 41 is a polyimide substrate, 41 is an aluminum substrate, 42 is a carbon thin film, 43 is a tungsten thin film, W is an X-ray absorption characteristic by tungsten, C is an X-ray absorption characteristic by carbon, 44 is a GaP substrate, 45, 47 are an AlP thin film layer, 46, 48 are a GaP thin film layer.

The present invention will be explained in detail as follows.

Microprocessing technique has been studied aiming at speeding-up and integration of semiconductor device. Moreover, at the present, devices have been invented based on a new principle with the aid of the quantum size effect of electron wave diffraction device and the like, and in order to materialize it, the processing technique of 10 nm order is required. It is therefore necessary to use X-ray having very short wavelength for exposure. However, an X-ray exposure mask of 10 nm order has not been manufactured at present.

The present invention proposes to provide a manufacture of an X-ray exposure mask by an epitaxial crystal growth method. The epitaxial crystal growth method can manufacture a superlattice of one atomic layer order, so that the mask manufactured by this method is favorable as an X-ray exposure mask of 10 nm order. The present invention further aims at clarification of the possibility of manufacturing a mask by this method by actual exposure.

A method of manufacturing a mask according to the present invention is to manufacture a superlattice by an epitaxial crystal growth method by alternately laminating a plurality of InP/GaInAs thin film layers on an InP substrate in the first place. The GaInAs layer is only etched by a sulfuric acid etching agent, and a comb-like mask is formed. In the present invention, an experiment was conducted by manufacturing masks of 400 nm pitch and 200 nm pitch respectively. With the use of these masks, X-ray was exposed to polymethyl methacrylate (PMMA) as a resist applied onto a silicon (Si) substrate. After development, it was observed that clear comb-like pattern was exposed in both 400 nm pitch and 200 nm pitch. It was confirmed from the above experiment that X-ray exposure can be carried out with the use of a superlattice as a mask.

Moreover, an X-ray mask exposure test was tried by selectively etching GaInAs in GaInAs/InP crystal, and as a result, a success of transcribing a 100 nm pattern has already been obtained.

### Embodiments

### Example 1

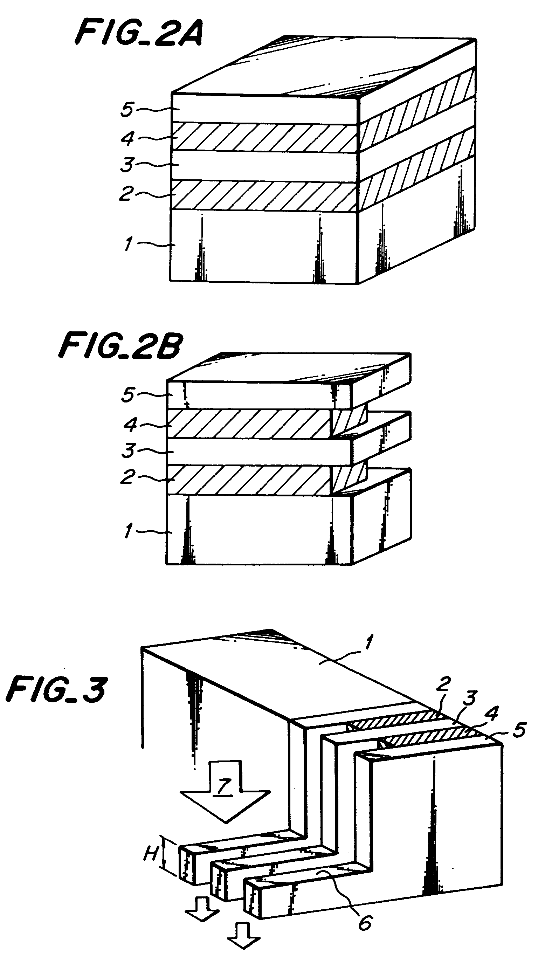

An embodiment of the present invention is explained detail, by the drawings. Fig. 2(A) shows the condition of successively applying a compound semiconductor GaInAs layer 2, an InP layer 3, a GaInAs layer 4 and an InP layer 5 onto an InP substrate 1 by a epitaxial crystal growth method. The epitaxial growth method was carried out by an organic metal vapor phase epitaxy (OMVPE).

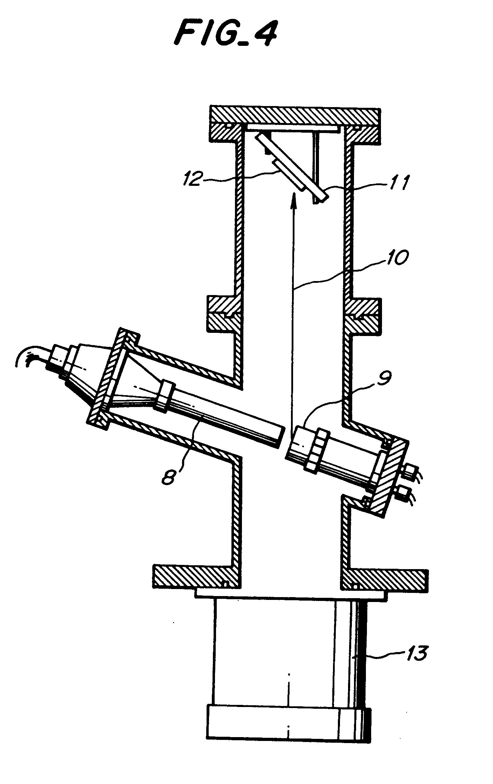

Fig. 2(B) shows the condition of selectively etching and removing a part of the GaInAs layers 2 and 4 by a sulfuric acid etching agent. The etched layer in this case is used as a comb-like X-ray exposure mask by forming uneven portions 6 by ion milling as shown in Fig. 3. Reference numeral 7 shows an X-ray irradiation direction, and shows irradiation in parallel to a cleavage surface of a thin film. In Fig. 3, when the portion H is more than 2000 Å, in case of irradiating X-ray, a streak-like pattern by a thickness of the thin film is formed on a resist by a difference of an X-ray absorption index. In this case, even if X-ray absorption coefficients of thin films are different or the same, a streak-like pattern can be formed.

### Example 2

A general outline of the method of manufacturing an X-ray mask by epitaxial crystal growth according to the present invention is explained.

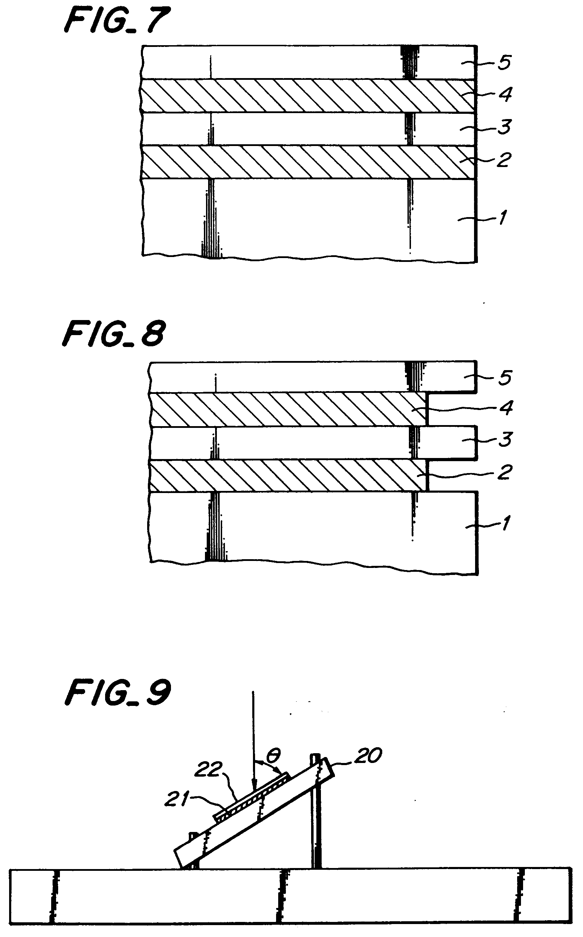

First, a superlattice is manufactured by alternately laminating materials having different X-ray absorption coefficients by metal organic chemical vapor deposition (MOCVD). Whereby, as an absorption coefficient of GaP is large and an absorption coefficient of AlP is small, the materials are alternately laminated on a substrate 1 such as an absorption coefficient (small), an absorption coefficient (large) and an absorption coefficient (small). When X-ray is incident in parallel to the interface of a thin film as shown in Fig. 6, an X-ray transmission wave becomes uneven in strength and the superlattice performs a role of a mask. Here, 18 is incident X-ray and 19 is output X-ray. The illustrated case shows the formation of a film such as an AlP layer 45, a GaP layer 46, an AlP layer 47 and a GaP layer 48 on a GaP substrate 44.

Therefore, in order to take a contrast of X-ray passed through the mask, the superlattice should be constructed by a combination of materials having large differences of absorption coefficient.

Here, an equation for giving an absorption coefficient of a compound consisting of atoms A, B, C, ··· is as follows. 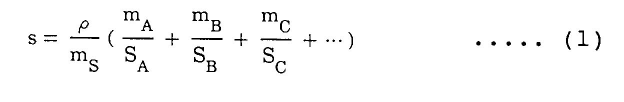
Here, ρ is the density of a compound semiconductor, S_{A}, S_{B}, S_{C} ··· are absorption coefficients of respective atoms, m_{A}, m_{B}, m_{C} ··· are atomic weights of respective atoms, and m_{S} is a molecular weight of the compound. Table 1 shows absorption coefficients of typical compound semiconductors.

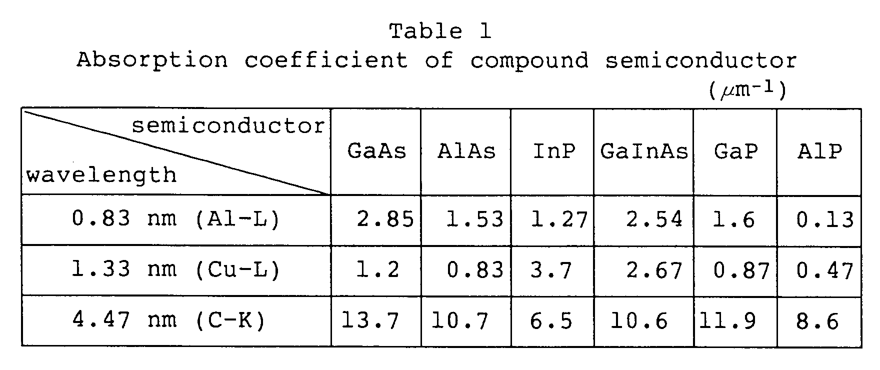

Moreover, material to be combined are restricted by lattice alignment, so that not too many different materials can be used. Within the range of Table 1, a combination of GaP and AlP is lattice alignment, in case of Al-L line (X-ray of wavelength 0.83 nm), if superlattice transmits 1.57m, X-ray passed through the GaP layer and X-ray passed through the AlP layer obtain a contrast 10, and are suitably used as a mask.

An experiment of the present invention was conducted by setting the condition within a range where the inventors could test. As materials, a combination of InP/GaInAs are lattice matched, and a superlattice was manufactured by an organic metal vapor phase growth method (OMVPE). Moreover, as X-ray, use was made of a Cu-L line (1.33 nm) owned by the inventors at present. In this case, absorption coefficients of X-ray are 3.7 (µm⁻¹) in InP and 2.7 (µm⁻¹) in GaInAs, and there is almost no difference. Therefore, a mask was manufactured by selectively etching GaInAs with a sulfuric acid etching agent.

There are grown respective three layers of InP/GaInAs superlattices of 400 nm pitch and 200 nm pitch respectively by the organic metal vapor phase growth method (OMVPE). (See Fig. 7)

The superlattice was cleared and its cleavage was etched with the use of a sulfuric acid etching agent (H₂SO₄:H₂O₂:H₂O=1:1:10) at 0°C for 2 minutes. Thereby the GaInAs layer is selectively etched. Its depth is 300 nm. The result is shown in Fig. 8.

### (2) Explanation of X-ray exposure device:-

Fig. 4 is a cross-sectional view of an X-ray exposure device. Reference numeral 8 is an electron gun, 9 is a Cu target, 10 is an X-ray, 11 is a stage, 12 is a sample, and an electron beam emitted from the electron gun 8 hits on the Cu target 9, and an X-ray of the emitted Cu-L line (wavelength λ=1.33 nm) hits on the sample 12 held by the stage 10. Reference numeral 13 is a vacuum pump.

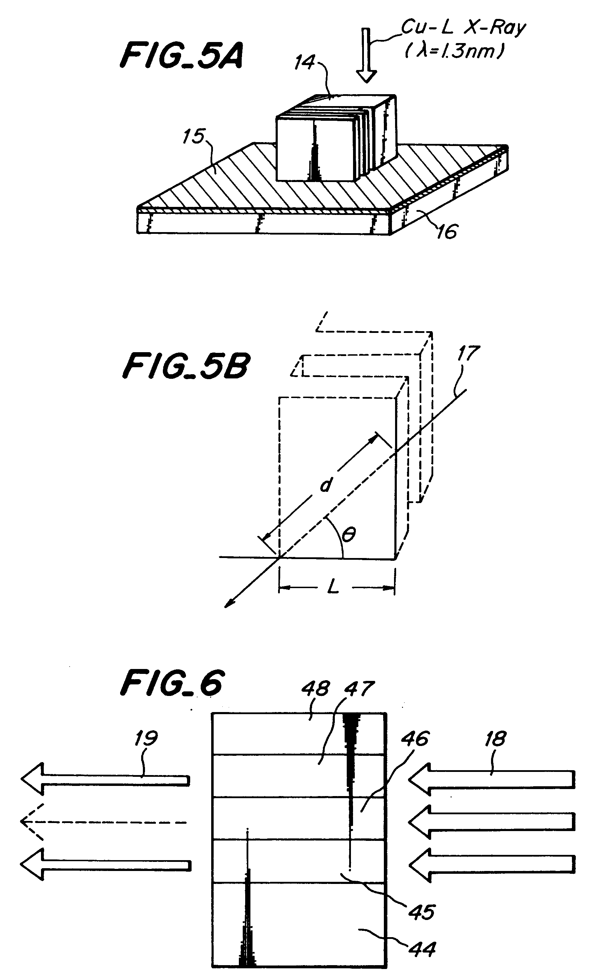

Fig. 5(A) shows the condition of manufacturing a streak-like X-ray mask pattern on a resist material 15 consisting of PMMA (polymethyl methacrylate) with the use of an X-ray exposure mask manufactured by the method according to the present invention by a difference of X-ray absorption amounts. Here, 16 is a silicon (Si) substrate.

Fig. 5(B) is an enlarged view showing a part of Fig. 5(A). In Fig. 5(B), let L be length acting as a mask and the depth of etching be L=300 nm.

$\text{L = dcosϑ}$

Here, d is optical path length of X-ray, and d=435 nm in experiment, and Q is an X-ray applying angle, and Q=45°. When InP absorption coefficient: $\text{α=3.7 µm-¹}$ and a contrast C=5,

$\text{C = exp(αd)}$

In the X-ray exposure device shown in Fig. 4, as an X-ray source, use is made of characteristic X-ray generated when the Cu target is excited by electron beam. An acceleration voltage of the excited electron gun 8 was made 6 kV, and the Cu-L line (λ=1.33 nm) only in the characteristic X-ray was exited. Electron energy converted into X-ray is about 0.1% and the rest becomes heat, so as to water cool for preventing the target from heating. The Cu-L line is long in wavelength in and weak in transmission, so that it is impossible to take X-ray outside through a beryllium (Be) window such as a usual sealed-type tube bulb, and hence, both the mask and the transcription substrate are put in a SUS tube bulb and the whole is exhausted to about 2×10⁻⁶ Torr by a vacuum pump 13 and used.

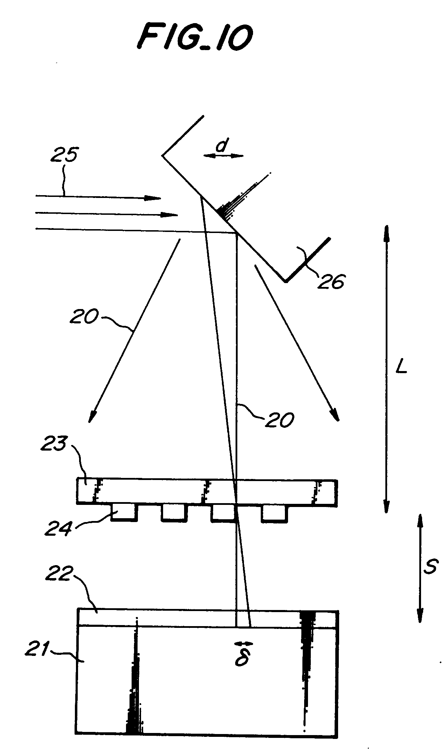

In order to put the present invention into practice, two points of a stage 11 and an extension tube were remodeled. First, there was newly manufactured a stage 11 which can freely change an angle with respect to a flange, and X-ray can be applied to a transcription substrate at a free angle. An outline of the flange is shown in Fig. 9.

Second, as to the extension tube, a distance from the Cu target to the transcription substrate was 9.0 cm, but it was made 39 cm by inserting a tube of 30 cm. If previous intensity is made I₀, intention I of X-ray in this case becomes as follows. 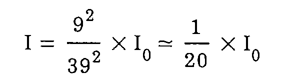
Therefore, it becomes possible to expose with a precision of 20 times.

Moreover, left the distance from the X-ray source to the mask be L and the gap between the mask and the substrate be s, there is generated a penumbral blur δ as shown in Fig. 10. Here, δ is expressed as follows.

$\text{δ = sd/L (2)}$

Therefore, the distance L can be earned by inserting an extension tube, and the penumbral blur δ can be controlled.

### (2) X-ray exposure process:-

### (1) Resist application

A one cm square silicon (Si) substrate is cut out, organically cleansed in order of methyl - trichlene - trichlene - methyl respectively for 5 minutes and substituted for pure water. PMMA (polymethyl methacrylate) (1:1) is applied thereto (first stage: 1 second 1000 rpm, second stage: 60 seconds 7000 rpm). Thereby PMMA (polymethyl methacrylate) is applied onto the Si substrate in thickness of 1800 Å. Thereafter, prebake is carried out at 170°C for 1 hour.

### (2) Exposure

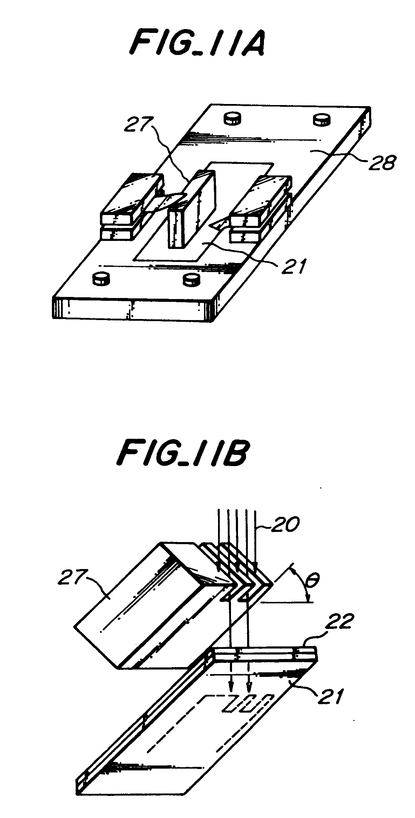

As shown in Fig. 11, a mask 27 and a transcription substrate 21 are pressed to a stage 28. Moreover, the stage 38 is inclined to 45° for suiting a distance passing X-ray through the mask 27. An exposure time is 3 minutes and 30 seconds.

### (3) Development

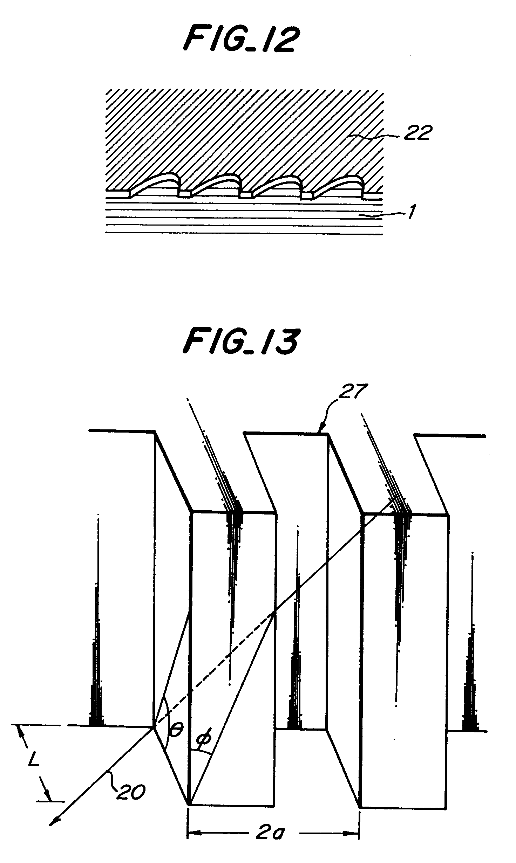

The transcription substrate 21 after exposure is developed with MIBK (methyl isobutyl ketone) 100% for 2 minutes, and rinsed with IPA (isopropyl alcohol) for 30 seconds. As a result, it was confirmed that a pattern of the mask 27 is transcribed to a resist. This is shown in Fig. 12.

### (4) Calculation of contrast

The maximum distance d transmitting X-ray through the InP layer of a mask portion is determined by the depth L of etching and the inclined angle ϑ as shown in Fig. 5(B). 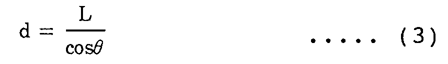
In the present experiment, L=200 nm, $\text{ϑ=π/4}$ , and d≃424 nm.

Moreover, the contrast C between vacuum when transmitting by the distance x and material of the absorption coefficient is expressed as follows.

$\text{C = EXP (αx) (4)}$

The X-ray absorption coefficient of InP is 3.7 µm-¹ and the contrast when transmitting 424 nm is about 4.8.

### (5) Allowable range of angular deviation

Let the pitch of a mask be 2a and the depth of etching be L, the limit angle φ of X-ray incident angle deviation in case of exposing with an angle φ is in the following relation as understood from Fig. 13. 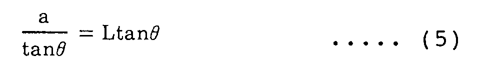
In the present invention, 2a=200 nm, L=300 nm, and $\text{ϑ=π/4}$ , so that 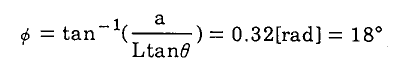
This is fully amendable range. However, if a pitch is made small, the depth of etching is limited from the intensity of InP, so that in order to make the contrast about 5 from the equations (3) and (4), ϑ should be made small. Therefore, the allowable limit of angle φ becomes small. For example, if the pitch is made 50 nm, φ=3.4°, angular alignment becomes very difficult. Moreover, in 30 nm pitch as a target of the present experiment, φ=2.0°. The matter of this angular alignment determined the present pitch limit.

### Reaction of PMMA:-

Positive type resist PMMA (polymethyl methacrylate) used in the present invention becomes low molecular cutting a resist high molecular chain of resist as shown in the following formula by non-elastic scattering and multi-stage reaction when X-ray, electron beam and the like are incident, and is solved in a developer. This resist is low in sensitivity and plasma resistance, but can be expected in the highest resolution at present.

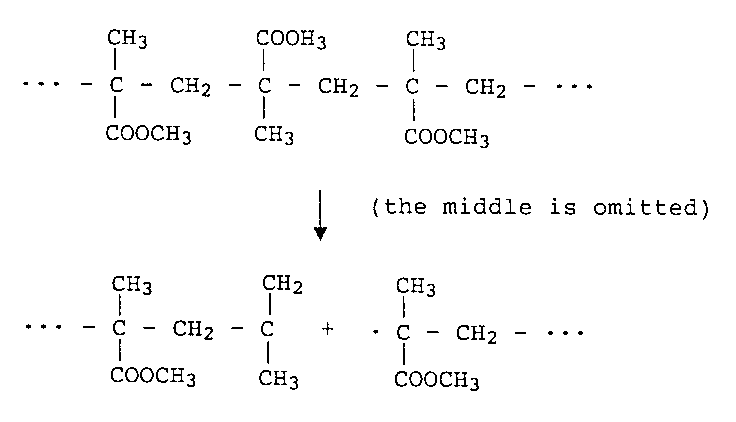

### Limit of X-ray exposure:-

An X-ray is short in wavelength and expected as a beam for exposure which pitch is very fine in future. However, as its energy is high, an absorption coefficient is small. Therefore, a mask used for X-ray exposure becomes thick, and X-ray should pass a narrow long waveguide path. In this case X-ray has a spread, and there is calculated how this spread is.

Here, let the X-ray be Cu-L line (1.33 nm), core be vacuum, and clad be InP. First, a refractive index n of InP is obtained by the following equation.

$\text{n = 1-2.7×10⁸ λ² zρ/A (6)}$

Here, Z is an atomic number, ρ is a density, A is an atomic number and λ is a wavelength of X-ray and is MSK unit series. Upon calculation, it becomes $\text{Δ=1-n=0.001}$ .

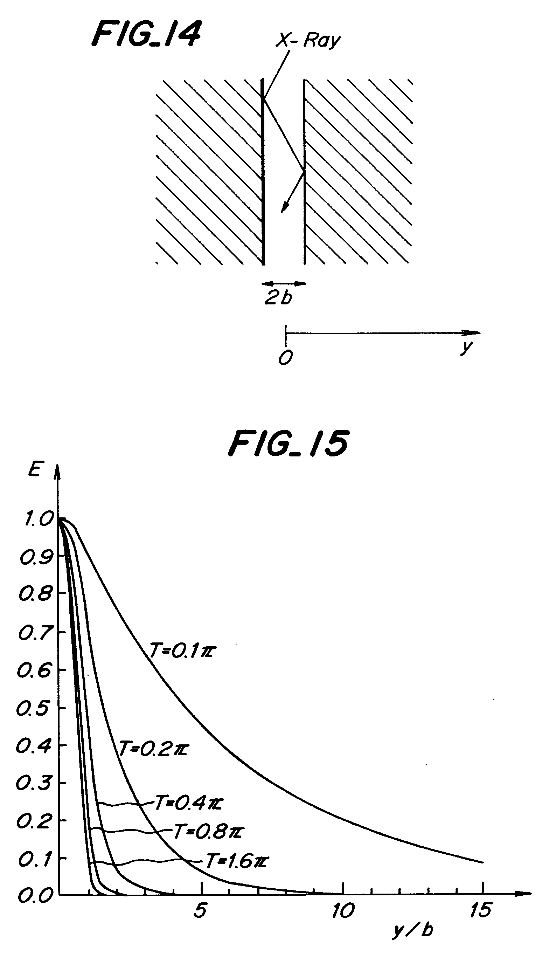

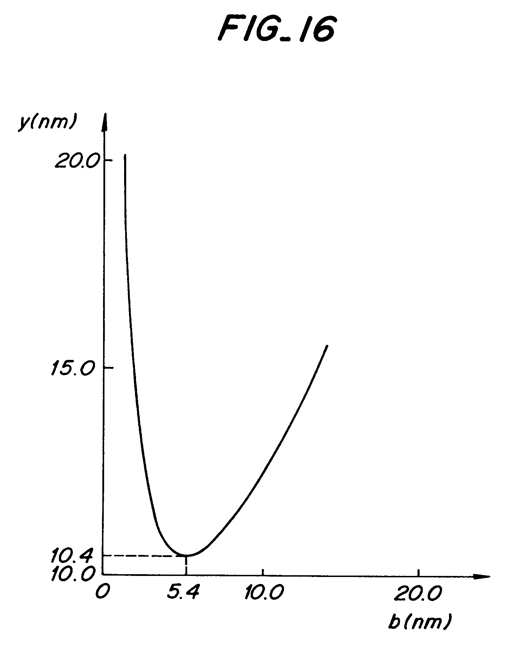

Here, when the width of the clad is made 2b, a y axis is taken as shown in Fig. 14, and a standardized waveguide path width T is determined, energy distribution is determined. However, T is as follows. 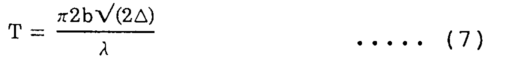
Energy distribution of each value of T is shown in Fig. 15. (Energy E standardizes the maximum value 1.)

When energy is 1/10 in Fig. 15, if a contrast is sufficiently taken, the minimum pitch of each value of T is determined, and when the determined minimum pitch is made 2y, a value of b is obtained from T, so that a graph of y to be is drawn. It is shown in Fig. 16.

When the width of a core is about 10 nm, it is understood that about 20 nm of the minimum pitch is obtained. This is a limit of the pitch formed by X-ray exposure when InP is used for clad.

### Effect of the Invention:-

The present invention alternately laminates two kinds of compound semiconductors as a thin film of about one atomic layer on a substrate of a crystal body with a periodic structure, selectively etches one material for forming this periodic structure, and formed uneven difference of more than at least 2000 Å between adjacent layers of said thin film laminate layers, so that even if X-ray absorption coefficients are the same in mutual thin films, a periodic structure is formed while there is a difference of sufficient X-ray absorption amounts, and as a result, by projecting X-ray on a desired resist through the mask, an X-ray exposure mask can be manufactured by exposing a streak at certain intervals. Here, according to the method of the present invention, it is easy to make a film thickness of a compound semiconductor applied to a substrate about 10 nm, and it is also easy to take an optical path length of more than 2000 Å by projecting X-ray to the direction or a laminate layer interface or cleavage of a thin film. Therefore, there is an industrially great effect of precisely manufacturing an X-ray mask pattern having a thickness of less than 10 nm by a difference of X-ray absorption amounts.

## Claims

1. A method of manufacturing an X-ray exposure mask comprising the steps of alternately laminating two kinds of compound semiconductors 2, 4 and 3, 5 as a thin film layer having a periodic structure with controlability of about one atomic layer on a substrate 1, selectively etching only one material for forming the periodic structure, forming an uneven difference between adjacent layers of said laminate body, and manufacturing a mask 14 for exposing streaks on a desired resist 15 with the aid of a difference of X-ray absorption amounts between each layer and by exposing X-ray in parallel to the direction of the laminate layer.

2. A method of manufacturing an X-ray exposure mask as claimed in claim 1, wherein the uneven difference formed between adjacent layers of said laminate body is more than 2000 Å.

3. A method of manufacturing an X-ray exposure mask as claimed in claim 1, wherein said substrate 1 is at least a crystal body.
